# NEUE EUROPÄISCHE PATENTSCHRIFT

(11) **EP 0 149 232 B2**
(45) Veröffentlichungstag und Bekanntmachung des Hinweises auf die Entscheidung über den Einspruch: **09.03.1994**
(45) Hinweis auf die Patenterteilung: 26.10.1988
(21) Anmeldenummer: 84116238.1
(22) Anmeldetag: 22.12.1984
(51) Int. Cl.: H01L 23/04, H01L 23/48, H01L 23/14

(54) **Halbleiterbauelement mit einem metallischen Sockel**
Semiconductor component having a metalic base
Composant semi-conducteur comprenant un socle métallique

(30) Priorität: 17.01.1984 DE 3401404
(43) Veröffentlichungstag der Anmeldung: 24.07.1985
(73) Patentinhaber: ROBERT BOSCH GMBH, 70442 Stuttgart (DE)
(72) Erfinder: Gademann, Lothar, Dipl.-Ing., D-7407 Rottenburg (DE); Tschepella, Johann, D-7410 Reutlingen (DE)

(56) Entgegenhaltungen:
- WO-A-82/03294
- DE-A- 1 817 596
- DE-A- 1 903 274
- DE-A- 2 363 725
- FR-A- 2 068 782
- FR-A- 2 344 173
- JP-A- 5 856 428
- US-A- 4 128 802

## Beschreibung

### Stand der Technik

Die Erfindung betrifft ein Halbleiterbauelement nach der Gattung des Hauptanspruchs.

Ein Halbleiterbauelement, bei dem ein scheibenförmiger Halbleiterkörper auf einen metallischen Sockel unmittelbar aufgelötet ist, ist beispielsweise aus der US-PS 3 584 265 bekannt. Ferner ist es bekannt, einen scheibenförmigen Halbleiterkörper auf einen metallischen Sockel mittelbar über einen dazwischengeschalteten Träger, der aus elektrisch leitendem Material besteht und die unterschiedlichen Wärmeausdehnungskoeffizienten von Sockel und Halbleiterkörper ausgleichen soll, aufzulöten.

Weiterhin sind Halbleiterbauelemente bekanntgeworden, bei denen die mit dem metallischen Sockel zu verlötende Unterseite des scheibenförmigen Halbleiterkörpers einen ganzflächigen elektrischen Anschlusskontakt des Halbleiterkörpers bildet und bei denen ferner an der Oberseite des scheibenförmigen Halbleiterkörpers mindestens ein flächenmässig eng begrenzter elektrischer Anschlusskontakt angebracht ist, von dem eine elektrische Verbindungsleitung zu einem äusseren Anschlussleiter des Halbleiterbauelements führt, der als Anschlussstift ausgeführt sein kann und dem flächenmässig eng begrenzten elektrischen Anschlusskontakt an der Oberseite des Halbleiterkörpers zugeordnet ist. Das Anbringen der elektrischen Verbindungsleitung kann dabei entweder in Löttechnik oder in Bondtechnik ausgeführt werden. Bei derartigen Halbleiterbauelementen ist es notwendig, den scheibenförmigen Halbleiterkörper vor dem Lötprozess mit Hilfe von Schablonen relativ zu dem Sockel zu fixieren.

Werden die elektrischen Verbindungsleitungen, die von den äusseren Anschlussleitern zu den Anschlusskontakten an der Oberseite des Halbleiterkörpers führen, am Halbleiterkörper und an den äusseren Anschlussleitern in Löttechnik angebracht, so besteht zwar die Möglichkeit, diese Anschlussleiter mit bestimmten Federeigenschaften auszustatten und mit ihrer Hilfe den Halbleiterkörper während des Lötprozesses an den metallischen Sockel federnd anzudrücken (US-PS 3 720 999), so dass die zur Justierung des Halbleiterkörpers auf dem Sockel verwendete Schablone vor dem Lötprozess wieder entfernt werden kann und Enfformungsprobleme hinsichtlich der Schablone nach dem Lötprozess somit entfallen (US-PS 3 689 985, US-PS 3 715 633 und US-PS 3711 752). Dieses Verfahren ist aber nur dann anwendbar, wenn der scheibenförmige Halbleiterkörper und die an seiner Oberseite angebrachten Anschlusskontakte verhältnismässig grossflächig ausgebildet sind und demzufolge an das Positionieren des Halbleiterkörpers relativ zum Sockel keine extrem hohen Anforderungen gestellt werden müssen. Ein Verrutschen des Halbleiterkörpers nach dem Entfernen der Schablone vor oder während des Lötprozesses kann aber hier nicht mit Sicherheit ausgeschlossen werden.

Um ein Verrutschen des Halbleiterkörpers vor dem Lötprozeß auszuschließen, ist es auch schon bekannt (DE-OS 19 03 274), das für das Verlöten erforderliche Lot zuerst auf den Sockel aufzuschmelzen, in das aufgeschmolzene Lot mittels eines Stempels eine Orientierungsgrube einzuprägen und den Halbleiterkörper dann in dieser Orientierungsgrube vor dem Lötprozeß unter Federkraft zu justieren.

Bei einer aus zwei Halbleitertabletten bestehenden Halbleitergleichrichteranordnung ist es aus der DE-OS 23 63 725 ferner bereits bekannt, die beiden zueinander elektrisch parallelgeschalteten Halbleitertabletten in je eine zylindrische Öffnung eines flachen Isolierstoffkörpers einzubringen, der mittels einer Metallisierungsschicht auf eine Kühlplatte aufgelötet wird, die gleichzeitig den Träger und je eine Elektrode der beiden Halbleitertabletten bildet. Die anderen Elektroden der beiden Halbleitertabletten sind mittels eines aus Metall bestehenden Kontaktteils miteinander verbunden, wobei das Kontaktteil mit den beiden Elektroden verlötet ist und der flache Isolierstoffkörper zur Justierung des Kontaktteils relativ zu den Elektroden dient.

Werden die elektrischen Verbindungsleitungen, die von den äusseren Anschlussleitern des Halbleiterbauelements zu den ihnen zugeordneten Anschlusskontakten an der Oberseite des Halbleiterkörpers führen, an dem Halbleiterkörper und an den zugehörigen äusseren Anschlussleitern in Bondtechnik angebracht (US-PS 4 128802), was insbesondere bei sehr kleinflächigen Halbleiterkörpern oder bei solchen mit sehr vielen Anschlusskontakten der Fall ist, so können die hierbei verwendeten Bonddrähte, falls der Halbleiterkörper mit seiner Unterseite an den Sockel angelötet wird, erst nach dem Lötprozess an dessen Oberseite angebracht werden, weil sie zur Fixierung des Halbleiterkörpers auf dem Sockel während des Lötprozesses nicht herangezogen werden können. Die zur Justierung des Halbleiterkörpers auf dem Sockel verwendete Formschablone kann hierbei erst nach dem Lötprozess wieder entfernt werden. Dabei treten in einer Mengenfertigung Entformungsprobleme auf. Wenn der Halbleiterkörper während des Lötprozesses gegen die Schablone schwimmt, kann er sich beim anschliessenden Abkühlvorgang verklemmen, und beim Entfernen der Schablone können am Rand des Halbleiterkörpers Kristallbrüche auftreten, die die Sperrfähigkeit und die elektrische Funktion des Halbleiterkörpers beeinträchtigen können.

### Vorteile der Erfindung

Das erfindungsgemässe Halbleiterbauelement mit den kennzeichnenden Merkmalen des Hauptanspruchs hat demgegenüber den Vorteil, dass ein mögliches Verklemmen des scheibenförmigen Halbleiterkörpers bei dem sich an den Lötprozess anschliessenden Abkühlvorgang mit der Lötschablone nicht mehr schädlich ist, weil diese im Gegensatz zu der bislang verwendeten Formschablone, die nach dem Lötprozess wieder entfernt wird, Bestandteil des Halbleiterbauelementes ist. Zur Justierung der verlorenen Lötschablone und des scheibenförmigen Halbleiterkörpers kann gemäss einer möglichen Ausführung des Verfahrens zur Herstellung des erfindungsgemässen Halbleiterbauelements eine Formschablone verwendet werden, die jetzt bei ihrem Entfernen nach dem Lötprozess allenfalls die verlorene Lötschablone, nicht aber den scheibenförmigen Halbleiterkörper, beschädigen kann. Weitere Vorteile ergeben sich aus den Unteransprüchen.

### Zeichnung

Ausführungsbeispiele des erfindungsgemässen Halbleiterbauelementes sind in der Zeichnung dargestellt und in der nachfolgenden Beschreibung näher erläutert. Es zeigen:
Figur 1 ein erstes Ausführungsbeispiel eines Halbleiterbauelements nach der Erfindung mit abgeschnittener Deckkappe in der Draufsicht;
Figur 2 einen Schnitt nach der Linie II-II der Figur 1;
Figur 3 eine Anordnung zum Justieren und Verlöten eines zweiten Ausführungsbeispiels eines Halbleiterbauelements nach der Erfindung in der Draufsicht;
Figur 4 einen Schnitt durch ein vormontiertes, noch nicht verlötetes Halbleiterbauelement mit einer Formschablone zum Justieren der verschiedenen Teile zueinander;
Figur 5 eine Draufsicht auf die Anordnung nach Figur 4;
Figur 6 ein drittes Ausführungsbeispiel eines Halbleiterbauelements nach der Erfindung mit abgeschnittener Deckkappe in der Draufsicht;
Figur 7 einen Schnitt nach der Linie VII-VII der Figur 6.

### Beschreibung der Ausführungsbeispiele

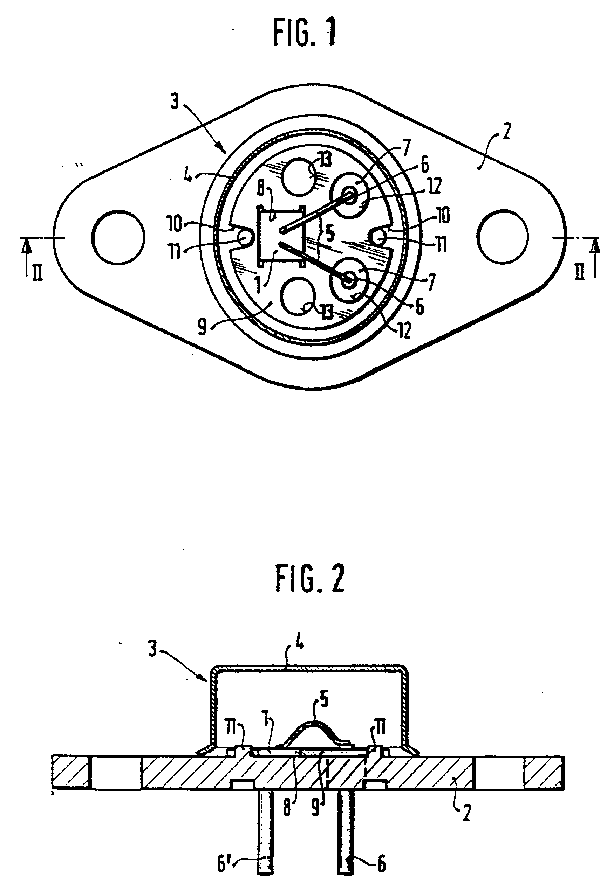

In den Figuren 1 und 2 ist ein Halbleiterbauelement in der Draufsicht und im Schnitt dargestellt, das einen als Transistor ausgebildeten scheibenförmigen Halbleiterkörper 1 enthält. Der Halbleiterkörper 1 trägt an seiner Unterseite einen ersten Anschlusskontakt, der sich über die ganze Unterseite erstreckt. Mit diesem Anschlusskontakt ist der Halbleiterkörper 1 auf einen metallischen Sokkel 2 aufgelötet, welcher einen Teil des Gehäuses 3 des Halbleiterbauelements bildet und gleichzeitig als Kollektoranschluss für den als Transistor ausgebildeten scheibenförmigen Halbleiterkörper 1 dient. Bestandteil des Gehäuses 3 ist ferner eine Deckkappe 4, die auf den metallischen Sockel 2 aufgeschweisst ist. Der obere Teil der Deckkappe 4 ist in Figur 1 abgeschnitten. An seiner Oberseite trägt der Halbleiterkörper 1 zwei weitere Anschlusskontakte, von denen der eine den Emitteranschluss und der andere den Basisanschluss des Transistors bildet. Von diesen beiden an der Oberseite angebrachten Anschlusskontakten führt je ein Bonddraht 5 zu einem pfostenförmigen Anschlussleiter 6, der über eine Glaseinschmelzung 7 isoliert durch den metallischen Sockel 2 hindurchgeführt ist. Ein dritter pfostenartiger Anschlussleiter 6', der nur in Figur 2 dargestellt ist, ist auf den Sockel 2 stumpf aufgeschweisst und bildet den äusseren Kollektoranschluss des Transistors.

Der scheibenförmige Halbleiterkörper 1 ist in eine Aussparung 8 einer auf den metallischen Sockel 2 aufgelöteten verlorenen Lötschablone 9 eingefügt. Die Kantenlänge der Aussparung 8 ist dabei um ca. 0,1 mm grösser als die Kantenlänge des Halbleiterkörpers 1 gewählt. Um die verlorene Lötschablone 9 und damit den scheibenförmigen Halbleiterkörper 1 auf dem metallischen Sockel 2 justieren zu können, sind am Umfang der Lötschablone 9 Einbuchtungen 10 und an dem metallischen Sockel 2 zwei Noppen 11 vorgesehen. Die Einbuchtungen 10 und die Noppen 11 sind so zueinander angeordnet, dass die verlorene Lötschablone 9 auf den metallischen Sockel 2 in einer definierten Lage unverrückbar aufgesetzt werden kann. Beim Ausführungsbeispiel nach den Figuren 1 und 2 ist die verlorene Lötschablone 9 kreisförmig ausgebildet und konzentrisch zu der sie umschliessenden Deckkappe 4 angeordnet. Die beiden Einbuchtungen 10 sind dabei am Umfang der verlorenen Lötschablone 9 einander diametral gegenüberliegend und die beiden Noppen 11 an dem metallischen Sockel 2 in entsprechender Lage angebracht.

Es versteht sich, dass diese Anordnung nur beispielhaft zu verstehen ist. Die Einbuchtungen 10 können auch an anderen Stellen des Umfangs der verlorenen Lötschablone 9 angebracht werden oder durch anders gestaltete Ausnehmungen ersetzt werden, die im Inneren der Lötschablone angebracht sein können.

Ausser der Aussparung 8, die den scheibenförmigen Halbleiterkörper 1 aufnimmt, ist in der verlorenen Lötschablone 9 für den Durchtritt der beiden pfostenartigen Anschlussleiter 6 je eine weitere Aussparung 12 vorgesehen, die kreisförmig ausgebildet ist und deren Durchmesser jeweils so gewählt ist, dass auch die Glaseinschmelzungen 7, die die beiden Anschlussleiter 6 aufnehmen, freiliegen, so dass ein Kurzschluss zwischen den verschiedenen Anschlüssen des Transistors vermieden wird.

In der Nähe der für den scheibenförmigen Halbleiterkörper 1 vorgesehenen Aussparung 8 enthält die verlorene Lötschablone 9 zwei weitere Aussparungen 13. In diese Aussparungen 13 sind vor dem Zusammenlöten der Anordnung Lotformteile eingelegt worden, die den Lotvorrat zum Anlöten des scheibenförmigen Halbleiterkörpers 1 und der verlorenen Lötschablone 9 an den metallischen Sockel 2 bildeten.

Bei der Herstellung des Halbleiterbauelements nach den Figuren 1 und 2 wird wie folgt verfahren:

Der aus Metall bestehende, bereits mit den Noppen 11 und mit Bohrungen für die Glaseinschmelzungen versehene Sockel 2, auf den bereits der ebenfalls aus Metall bestehende pfostenartige Anschlussleiter 6' stumpf aufgeschweisst ist, wird zunächst an seiner ganzen Oberfläche einschliesslich der des pfostenartigen Anschlussleiters 6' mit einer korrosionsbeständigen und lötfähigen metallischen Schicht, die vorzugsweise aus Nickel besteht, überzogen. Dann werden die pfostenartigen Anschlussleiter 6 in die Bohrungen des metallischen Sockels 2 eingeschmolzen und auf diese Weise mit Hilfe der Glaseinschmelzungen 7 durch den Sockel 2 isoliert hindurchgeführt.

Nun wird die verlorene Lötschablone 9, die vorzugsweise aus Kupfer besteht und vernickelt ist, auf den Sockel 2 aufgesetzt und dabei mit Hilfe der Noppen 11 des Sockels 2 und der an ihr angebrachten Einbuchtungen 10 relativ zu dem Sockel 2 justiert. Dann wird in die Aussparung 8 der scheibenförmige Halbleiterkörper 1 und in die Aussparungen 13 jeweils ein in den Figuren 1 und 2 nicht dargestelltes Lotformteil eingelegt und die so montierte Anordnung durch den Lötofen transportiert.

Beim Lötprozess wird das in die Aussparungen 13 in Form der Lotformteile eingebrachte Lot geschmolzen und wandert unter der Wirkung der Kapillarkraft unter die Lötschablone 9 und unter den scheibenförmigen Halbleiterkörper 1 und bewirkt, dass diese beiden Teile 9 und 1 gleichzeitig auf den metallischen Sockel 2 aufgelötet werden.

Nach der Entnahme der so verlöteten Anordnung aus dem Lötofen werden in einem besonderen Arbeitsgang die Bonddrähte 5 angebracht, die von den Anschlusskontakten an der Oberseite des scheibenförmigen Halbleiterkörpers 1 zu den pfostenartigen Anschlussleitern 6 führen.

Das auf diese Weise vollständig kontaktierte Halbleiterbauelement wird anschliessend mit der Deckkappe 4 versehen, die auf den metallischen Sockel 2 aufgeschweisst wird.

Es versteht sich von selbst, dass die Erfindung nicht auf die anhand der Figuren 1 und 2 beschriebene Anordnung beschränkt ist. Anstelle eines einzigen Halbleiterkörpers können auch mehrere Halbleiterkörper gleichzeitig auf den metallischen Sockel 2 unter Verwendung einer einzigen verlorenen Lötschablone aufgelötet werden, die für jeden dieser Halbleiterkörper eine besondere Aussparung enthält. Auch besteht die Möglichkeit, den oder die Halbleiterkörper zusammen mit der verlorenen Lötschablone gegen den metallischen Sockel 2 elektrisch zu isolieren. Dies kann dadurch geschehen, dass in die Anordnung zwischen den metallischen Sockel und das aus Halbleiterkörper und Lötschablone bestehende System eine isolierende Platte, beispielsweise aus Keramik, eingelötet wird.

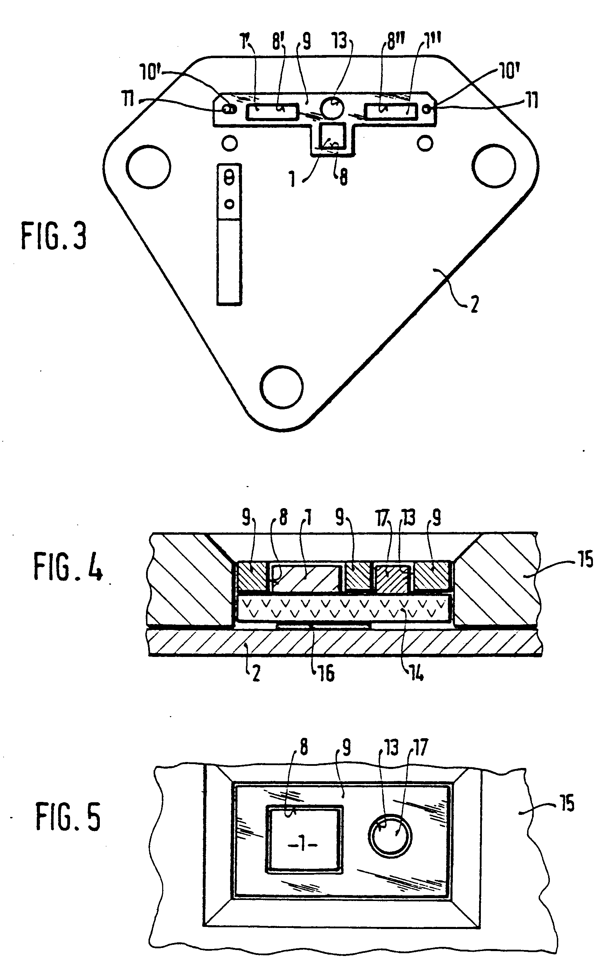

Figur 3 zeigt beispielhaft eine Anordnung, bei der auf einen gemeinsamen metallischen Sockel drei plättchenförmige Halbleiterkörper 1, 1', 1'' unter Verwendung einer einzigen verlorenen Lötschablone 9 aufgelötet werden können. Hierzu sind in der Lötschablone 9 Aussparungen 8, 8', 8'' vorgesehen. Die Justierung erfolgt mit Hilfe zweier an dem Sockel 2 angebrachter Noppen 11, die in weitere Aussparungen 10' der Lötschablone 9 eingreifen. Zur Aufnahme eines Lotformteils dient eine weitere Aussparung 13.

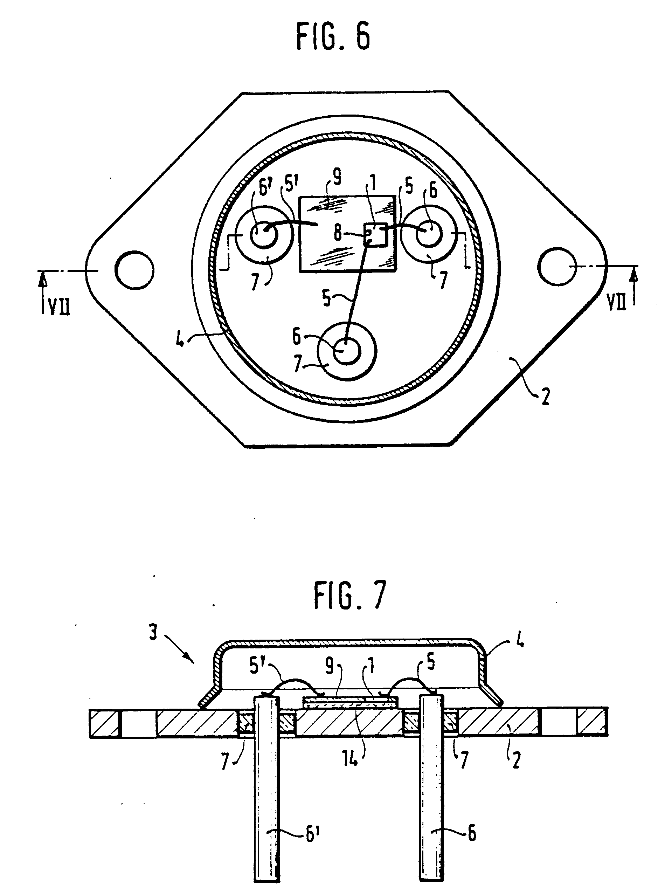

Die Figuren 4 und 5 zeigen ein in Herstellung begriffenes Halbleiterbauelement vor dem Verlöten gemäss einem weiteren Vorschlag der Erfindung. Bei diesem Ausführungsbeispiel ist vorgesehen, dass ein als Transistor ausgebildeter Halbleiterkörper 1 mit seinem an der Unterseite ganzflächig angebrachten Kollektoranschluss auf einen metallischen Sockel 2 isoliert aufgelötet werden soll. Zur Isolierung dient hierbei eine beidseitig metallisierte Keramikplatte 14 aus Berylliumoxid, die zwischen dem aus der verlorenen Lötschablone 9 und dem Halbleiterkörper 1 einerseits und den Sockel 2 andererseits bestehenden System eingelötet wird. Die Metallisierung der Keramikplatte 14 kann als oberste Schicht einen Goldüberzug enthalten.

Auf den metallischen Sockel 2 wird eine Formschablone 15 aufgelegt. In eine Aussparung der Formschablone 15 wird zuerst ein Lotformteil 16 und anschliessend die Keramikplatte 14 eingelegt, die auf diese Weise auf das Lotformteil 16 zu liegen kommt und die in der Formschablone 15 befindliche Aussparung bis auf einen schmalen freigelassenen Rand vollständig ausfüllt. Auf die Keramikplatte 14 wird eine verlorene Lötschablone 9 aufgelegt, deren äussere Abmessungen genau denen der Keramikplatte 14 entsprechen und die eine Aussparung 8 für den Halbleiterkörper 1 und eine Aussparung 13 für ein weiteres Lotformteil 17 besitzt. Nach dem Auflegen der Lötschablone 9 auf die Keramikplatte 14 werden in die in dieser Schablone vorgesehenen Aussparungen 8 und 13 der Halbleiterkörper 1 und das Lotformteil 17 eingelegt und danach das so montierte System durch den Lötofen transportiert. Hier erfolgt die Verlötung in der bereits weiter oben beschriebenen Weise.

Die Aussparung 13 in der verlorenen Lötschablone 9 kann entfallen, wenn anstelle des Lotformteils 17 ein Lotformteil verwendet wird, das unter den Halbleiterkörper 1 oder unter die verlorene Lötschablone 9 gelegt wird, oder wenn die verlorene Lötschablone 9 und/oder der Halbleiterkörper 1 an der jeweiligen Unterseite mit einer Lotschicht versehen ist.

Der Unterschied gegenüber dem Ausführungsbeispiel nach den Figuren 1 und 2 besteht darin, dass beim vorliegenden Ausführungsbeispiel der auf den metallischen Sockel 2 aufgelötete Halbleiterkörper 1 gegen diesen durch die Keramikplatte 14 isoliert wird. Dies führt dazu, dass der an der Unterseite des Halbleiterkörpers 1 liegende Kollektoranschluss ebenso wie die an seiner Oberseite liegenden Elektroden (Basis- und Emitteranschluss) von der Oberseite des Systems her zu kontaktieren ist, wozu die verlorene Lötschablone 9 Verwendung findet. An dieser Lötschablone 9 kann ein dünner Metalldraht für den Anschluss des Kollektors in gleicher Weise wie für den Emitter- und Basiskontakt angeschweisst werden. Beim Anbringen des Metalldrahts in Bondtechnik (Schweissen) kann die verlorene Lötschablone 9 zuvor mit einer dünnen Schicht aus Aluminium oder Nickel, versehen werden.

Das so hergestellte fertige Bauelement ist in den Figuren 6 und 7 dargestellt. Sämtliche nach aussen geführten Anschlussdrähte gehen hier von der Oberseite des aus dem Halbleiterkörper 1 und der verlorenen Lötschablone 9 gebildeten Systems aus. Wie beim Ausführungsbeispiel nach den Figuren 1 und 2 führt jeweils ein Bonddraht 5 vom Emitter- und Basiskontakt zu einem besonderen pfostenartigen Anschlussleiter 6, der isoliert durch den Sockel 2 hindurchgeführt ist. Im Gegensatz zu dem Ausführungsbeispiel nach den Figuren 1 und 2 ist auch der Kollektor über einen Bonddraht kontaktiert, der hier mit 5' bezeichnet ist und von der verlorenen Lötschablone 9 zu einem pfostenartigen Anschlussleiter 6' führt, der wie die beiden anderen pfostenartigen Anschlussleiter 6 über eine Glaseinschmelzung 7 isoliert durch den Sockel 2 hindurchgeführt ist.

## Patentansprüche

1. Halbleiterbauelement, bei dem mindestens ein scheibenförmiger Halbleiterkörper (1) auf einen metallischen Sockel (2) unmittelbar oder über einen dazwischengeschalteten Träger (14) mittelbar aufgelötet ist und bei dem der scheibenförmige Halbleiterkörper (1) an seiner Oberseite mindestens einen flächenmäßig eng begrenzten elektrischen Anschlußkontakt aufweist, von dem eine als dünner Metalldraht ausgebildete elektrische Verbindungsleitung (5) zu einem äußeren Anschlußleiter (6) des Halbleiterbauelements führt, der dem flächenmäßig eng begrenzten elektrischen Anschlußkontakt zugeordnet ist, wobei die elektrische Verbindungsleitung (5) mit dem flächenmäßig eng begrenzten elektrischen Anschlußkontakt und mit dem diesem Anschlußkontakt zugeordneten äußeren Anschlußleiter (6) des Halbleiterbauelements an dem jeweiligen Drahtende verschweißt ist, dadurch gekennzeichnet, daß der scheibenförmige Halbleiterkörper (1) in eine Aussparung (8) einer ebenfalls auf den metallischen Sockel (2) unmittelbar oder über den dazwischengeschalteten Träger (14) mittelbar aufgelöteten verlorenen Lötschablone (9) eingefügt ist.

2. Halbleiterbauelement nach Anspruch 1, bei dem der scheibenförmige Halbleiterkörper (1) auf den metallischen Sockel (2) über den dazwischengeschalteten Träger (14) mittelbar aufgelötet ist, dadurch gekennzeichnet, daß der dazwischengeschaltete Träger (14) aus elektrisch isolierendem Material besteht.

3. Halbleiterbauelement nach Anspruch 2, dadurch gekennzeichnet, daß der dazwischengeschaltete Träger (14) aus Keramik, vorzugsweise aus Berylliumoxid, besteht.

4. Halbleiterbauelement nach Anspruch 2 oder 3, bei dem die mit dem dazwischengeschalteten Träger (14) verlötete Unterseite des scheibenförmigen Halbleiterkörpers (1) einen weiteren elektrischen Anschlußkontakt bildet, dadurch gekennzeichnet, daß die verlorene Lötschablone (9) als elektrischer Zuführungsleiter zu diesem weiteren elektrischen Anschlußkontakt dient und daß von ihr eine weitere, als dünner Metalldraht ausgebildete elektrische Verbindungsleitung (5') zu einem weiteren, dem an der Unterseite des scheibenförmigen Halbleiterkörpers (1) angebrachten elektrischen Anschlußkontakt zugeordneten äußeren Anschlußleiter (6') des Halbleiterbauelements führt, wobei die weitere elektrische Verbindungsleitung (5') mit der verlorenen Lötschablone (9) und mit dem weiteren äußeren Anschlußleiter (6') des Halbleiterbauelements an dem jeweiligen Drahtende verschweißt ist.

5. Halbleiterbauelement nach einem der Ansprüche 1 bis 4, dadurch gekennzeichnet, daß Mittel (10, 10'; 11) zur Lagefixierung der verlorenen Lötschablone (9) relativ zu dem metallischen Sockel (2) vorgesehen sind.

6. Halbleiterbauelement nach Anspruch 5, dadurch gekennzeichnet, daß an dem Sockel (2) mindestens ein Vorsprung (11) angebracht ist, der die Lage der Lötschablone (9) relativ zum Sockel (2) festlegt.

7. Halbleiterbauelement nach Anspruch 6, dadurch gekennzeichnet, daß mindestens zwei räumlich eng begrenzte Vorsprünge (11) vorgesehen sind, die in mindestens zwei Aussparungen (10; 10') eingreifen, die an der verlorenen Lötschablone (9) und gegebenenfalls an dem zwischen dem Sockel (2) und der verlorenen Lötschablone (9) vorgesehenen Träger (14) angebracht sind.

8. Halbleiterbauelement nach einem der Ansprüche 1 bis 7 mit mehreren scheibenförmigen Halbleiterkörpern (1, 1', 1''), dadurch gekennzeichnet, daß für sämtliche Halbleiterkörper (1, 1', 1'') eine gemeinsame verlorene Lötschablone (9) vorgesehen ist, die für jeden der Halbleiterkörper (1, 1', 1'') eine besondere Aussparung (8, 8', 8'') enthält, in die der jeweilige Halbleiterkörper (1, 1', 1'') eingefügt ist.

## Claims

1. Semiconductor component, in which at least one disc-shaped semiconductor body (1) is directly soldered onto a metallic base (2) or indirectly via an interposed carrier (14) and in which the disc-shaped semiconductor body (1) exhibits at its top at least one electric connecting contact with narrow area limits, from which an electric connecting line (5) in the form of a thin metal wire leads to an external terminal conductor (6) of the semiconductor component which is associated with the electric connecting contact having narrow area limits, the electric connecting line (5) being welded to the electric connecting contact having narrow area limits and to the outer connecting conductor (6), associated with this connecting contact, of the semiconductor component at the respective wire end, characterized in that the disc-shaped semiconductor body (1) is inserted into a recess (8) of a lost soldering template (9) which is also directly, or indirectly via the interposed carrier (14), soldered onto the metallic base (2).

2. Semiconductor component according to Claim 1, in which the disc-shaped semiconductor body (1) is indirectly soldered onto the metallic base (2) via the interposed carrier (14), characterized in that the interposed carrier (14) consists of electrically insulating material.

3. Semiconductor component according to Claim 2, characterized in that the interposed carrier (14) consists of ceramics, preferably of beryllium oxide.

4. Semiconductor component according to Claim 2 or 3, in which the underside of the disc-shaped semiconductor body (1) soldered to the interposed carrier (14) forms a further electric connecting contact, characterized in that the lost soldering template (9) is used as electric feed conductor to this further electric connecting contact and that from it a further electric connecting line (5') in the form of a thin metal wire leads to a further, outer terminal conductor (6') of the semiconductor component which is associated with the electric connecting contact attached to the underside of the disc-shaped semiconductor body (1), the further electric connecting line (5') being welded to the lost soldering template (9) and to the further, outer connecting conductor (6') of the semiconductor component at the respective wire end.

5. Semiconductor component according to one of Claims 1 to 4, characterized in that means (10, 10'; 11) are provided for fixing the location of the lost soldering template (9) relative to the metallic base (2).

6. Semiconductor component according to Claim 5, characterized in that at least one projection (11), which fixes the location of the soldering template (9) relative to the base (2), is attached to the base (2).

7. Semiconductor component according to Claim 6, characterized in that at least two spatially narrowly limited projections (11) are provided which engage in at least two recesses (10; 10') which are provided in the lost soldering template (9) and, if necessary, at the carrier (14) provided between base (2) and soldering template (9).

8. Semiconductor component according to one of Claims 1 to 7, having several disc-shaped semiconductor bodies (1, 1', 1''), characterized in that a common lost soldering template (9), which contains a separate recess (8, 8', 8'') for each of the semiconductor bodies (1, 1', 1'', into which the respective semiconductor body (1, 1', 1'') is inserted, is provided for all semiconductor bodies (1, 1', 1'').

## Revendications

1. Composant semi-conducteur comprenant un élément semi-conducteur (1) en forme de pastille soudé directement sur un socle métallique (2) ou indirectement par un support intermédiaire (14), l'élément semi-conducteur (1) en forme de pastille comportant sur sa face supérieure au moins un contact de liaison électrique de surface étroitement limitée relié par une ligne de liaison électrique (5) formée d'un fil métallique fin à un conducteur de liaison (6) extérieur du composant semi-conducteur associé au contact de liaison électrique à surface étroitement limitée, la ligne de liaison électrique (5) étant soudée au contact de liaison à surface étroitement limitée et à ce conducteur de liaison (6), extérieur, associé à ce contact de liaison du composant semi-conducteur à l'extrémité respective du fil, caractérisé en ce que l'élément semi-conducteur en forme de pastille (1) est introduit dans une cavité (8) d'un gabarit de soudage perdu (9) également soudé directement sur le socle métallique (2) ou indirectement par un support intermédiaire (14).

2. Composant semi-conducteur selon la revendication 1, dans lequel l'élément semi-conducteur (1) en forme de pastille est soudé indirectement sur le socle métallique (2) par à un support intermédiaire (14), caractérisé en ce que le support intermédiaire 14 est constitué d'un matériau isolant électrique.

3. Composant semi-conducteur selon la revendication 2, caractérisé en ce que le support intermédiaire (14) est en céramique, en particulier en oxyde de béryllium.

4. Composant semi-conducteur selon la revendication 2 ou 3, dont la face inférieure de l'élément semi-conducteur (1) soudée au support intermédiaire (14) forme un contact de liaison électrique, caractérisé en ce que le gabarit de soudage perdu (9) sert de conducteur d'alimentation électrique de cet autre contact de liaison et en ce qu'à partir de ce contact une autre ligne de liaison électrique 5' formée d'un fil métallique fin mène à un autre conducteur de liaison extérieur 6' du composant semi-conducteur associé au contact de liaison électrique en étant rapporté à la face inférieure de l'élément semiconducteur (1).

5. Composant semi-conducteur selon l'une des revendications 1 à 4, caractérisé par des moyens (10, 10', 11) pour fixer en place le gabarit de soudage perdu (9) sur socle métallique (2).

6. Composant semi-conducteur selon la revendication 5, caractérisé en ce que, le socle (2) comporte au moins une saillie (11) qui détermine la position du gabarit de soudage perdu (9) par rapport au socle (2).

7. Composant semi-conducteur selon la revendication 6, caractérisé par au moins deux saillies étroitement limitées dans l'espace qui s'engagent dans au moins deux cavités (10, 10') pratiquées sur le gabarit de soudage perdu (9) et, le cas échéant, sur le support (14) placé entre le socle (2) et le gabarit de soudage (9).

8. Composant semi-conducteur selon l'une des revendications 1 à 7, comportant plusieurs éléments semi-conducteurs en forme de pastille (1, 1', 1''), caractérisé par un gabarit de soudage perdu (9) commun à l'ensemble des éléments semi-conducteurs (1, 1', 1'') qui comporte pour chacun des éléments semiconducteurs (1, 1', 1''), une cavité particulière (8, 8', 8'') recevant chacune un élément semi-conducteur (1, 1', 1'').
